# EUROPEAN PATENT APPLICATION

(11) **EP 1 406 187 A1**
(43) Date of publication of application: **07.04.2004**
(21) Application number: 02743831.6
(22) Date of filing: 04.07.2002
(51) Int. Cl.: G06F 17/50

(54) **METHOD FOR STORING ENTITY DATA IN WHICH SHAPE AND PHYSICAL QUANTITY ARE INTEGRATED AND STORING PROGRAM**

(30) Priority: 11.07.2001 JP 2001210508
(71) Applicant: Riken, Wako-shi, Saitama 351-0198 (JP)
(72) Inventor: YAMADA, Tomonori, c/o RIKEN, Wako-shi, Saitama 351-0198 (JP); KASE, Kiwamu, c/o RIKEN, Wako-shi, Saitama 351-0198 (JP); MIYAMURA, Tomoshi, c/o RIKEN, Wako-shi, Saitama 351-0198 (JP); TESHIMA, Yoshinori, c/o RIKEN, Wako-shi, Saitama 351-0198 (JP); MAKINOUCHI, Akitake, c/o RIKEN, Wako-shi, Saitama 351-0198 (JP)
(74) Representative: Grünecker, Kinkeldey, Stockmair & Schwanhäusser Anwaltssozietät
(86) International application number: PCT/JP2002/006789
(87) International publication number: WO 2003/009183

(57) **Abstract**

There is disclosed a method comprising an external data entering step (A), a shape data dividing step (B) for dividing the external data into cubic shape cells 13 having boundary planes orthogonal to one another based on octree division, and storing shape data for each cell, and a physical quantity dividing step (C) for dividing a physical quantity of the object into different physical quantity cells 13' for each physical quantity based on octree division, and storing each physical quantity for each physical quantity cell. The shape cell 13 and each physical quantity cell 13' for each physical quantity are stored on different memory layers 18 in the same coordinate system, and managed in correlation with each other. In addition, the plurality of memory layers 18 are used singly or in combination for use of the data of the shape and the physical quantity.

## Description

### BACKGROUND OF THE INVENTION

### Field of the Invention

The present invention relates to a method and a device for storing substance data, capable of storing the substance data integrating a shape and a physical quantity with a small storage capacity, and unifying CAD and simulation.

### Description of the Related Art

In a field of a cutting-edge research and development/technological development, a great deal of trial and error has become essential following a higher level of development and complexity, increasing risks during development. In Japan which founds itself on the basis of science and technology, it is extremely important to achieve innovatively higher level and higher efficiency of a development process by removing such risks as much as possible.

At present, in the field of research and development/technological development, Computer Aided Design (CAD), Computer Aided Manufacturing (CAM), Computer Aided Engineering (CAE), Computer Aided Testing (CAT), and the like are used as simulation means of designing, processing, analyzing and testing.

Also, it is expected that Coorparative Simulation (C-Simulation) as continuous simulation, Advanced CAM (A-CAM considering even a fabrication process, Deterministic fabrication (D-fabrication) obtaining ultimate accuracy, and the like will become widespread by the present invention.

In the above-described conventional simulation means, data on an object is stored in Constructive Solid Geometry (CSG), or Boundary Representation (B-rep).

However, in the case of the CSG, the entire object is stored as an aggregate of micro solid models. Thus, when data is heavy and simulation means (software or the like) is mounted, an enormous amount of data must be processed. Therefore, a problem has been inherent, i.e., analysis takes time even if a mainframe is used.

In the case of the B-rep, as the object is represented by a boundary, data is light and an amount of data is small. However, a problem has been inherent, i.e., it is not suitable to deformation analysis or the like, because of uniform processing inside a boundary face.

Further, in the above-described conventional data storing means, for each heat/fluid analysis, solid large deformation analysis, coupled analysis thereof or the like, division is made into a mesh or the like suited to the analysis, and a finite element method or the like is used. Accordingly, it is difficult to unify CAD and simulation while a result of the analysis can be displayed or the like. Thus, a problem has been inherent, i.e., it is impossible to manage steps of designing, analyzing, fabricating, assembling, testing and the like by the same data.

In other words, the following problems have been inherent in the conventionally used Solid/Surface-CAD (referred to as S-CAD, hereinafter).
(1) Data cannot be passed, and internal conversion operation cannot be performed well (problems of a numerical value error and a processing method).
(2) Direct application to simulation is impossible (a mesh must be generated because of no internal information).
(3) Processing by CAD cannot be examined (only an end shape is provided).

The following problems have been inherent in processing.
(1) A fabrication process cannot be represented (assistance to rough processing or step designing is insufficient).
(2) A new processing method such as laser beam machining or superhead processing cannot be dealt with (only cutting is carried out, and numerical accuracy is insufficient).
(3) A processing method itself cannot be selected (a complex, having different material characteristics inside).

To solve the foregoing problems, the inventors invented "Method for storing substance data integrating shape and physical property" capable of storing substance data integrating a shape and a physical property with a small storage capacity, and applied for patent (Patent Application No. 2001-25023: not yet open) .

This invention enabled a shape, a structure, physical property information and history of an object to be managed in a unified manner, data regarding a series of steps from designing to fabricating, assembling, testing and evaluating, to be managed by the same data, unifying CAD simulation.

According to the above-described invention filed, external data containing shape data of the object is divided into cubic cells having boundary planes orthogonal to one another based on octree (oct-tree) division, and various physical property values are stored for each cell. The divided cells are composed of an internal cell positioned inside the object, and a boundary cell including a boundary face. The internal cell has one kind of a physical property value as an attribute, and the boundary cell has two kinds of physical property values of the inside and outside of the object.

Data by this method is referred to as "V-CAD data", and designing or simulation using this data is referred to as "volume CAD" or "V-CAD).

As described above, in the V-CAD, each physical quantity is stored in the octree cell. Accordingly, in the V-CAD, if unconformity is present between cell division proper for specific shape representation and storage cell division proper for a physical quantity, the divisions must be unified into either one of such divisions, or new cell division for sufficiently representing all physical quantity distributions must be prepared. It is because initial cell division of the V-CAD is one proper for storing data of "specific shape representation", but not necessarily proper for storing other data, e.g., physical properties.

Therefore, in the case of setting a plurality of physical quantities such as a stress distribution, a temperature distribution, and a flow velocity distribution other than shape data as "V-CAD data" of the above-described invention filed, the plurality of physical quantities are stored in the most meticulously divided cells, enlarging a necessary memory. As a result, unnecessary extension of display time, impossibility of efficiently using data, and other problems have been inherent.

### SUMMARY OF THE INVENTION

The present invention was made to solve the foregoing problems. That is, objects of the invention are to provide a method and a device for storing substance data, capable of highly accurately storing substance data integrating a shape and a plurality of physical quantities by a small storage capacity without changing initial V-CAD cell information, thereby enabling a shape, a structure, physical quantity information, and history of an object to be managed in a unified manner, data regarding a series of steps of designing to fabricating, assembling, testing and evaluating to be managed by the same data, and CAD and simulation to be unified.

According to the present invention, a method for storing substance data integrating a shape and a physical quantity is provided. This method comprises: an external data entering step (A) for entering external data (12) containing shape data of an object (1); a shape data dividing step (B) for dividing the external data into cubic shape cells (13) having boundary planes orthogonal to one another by octree division, and storing shape data for each cell; and a physical quantity dividing step (C) for dividing a physical quantity of the object into different physical quantity cells (13') for each physical quantity by octree division, and storing each physical quantity for each physical quantity cell.

According to the present invention, an arithmetic memory device for storing substance data integrating a shaped and a physical quantity is provided. This arithmetic memory device comprises: an input unit (2) for entering external data (12) containing shape data of an object (1); an external memory (3) for storing the substance data integrating the shape and the physical quantity, and its arithmetic memory program; an internal memory (4) and a central processing unit (5) for executing the memory program; and an output unit (6) for outputting a result of the execution, wherein the external data is divided into cubic shape cells (13) having boundary planes orthogonal to one another by octree division, shape data is stored for each shape cell, the physical quantity of the object (1) is octree-divided into different physical quantity cells (13') for each physical quantity, and each physical quantity is stored for each physical quantity cell.

According to a preferred embodiment of the present invention, the shape cell (13) and the physical quantity cell (13') for each physical quantity are stored on different memory layers (18) in the same coordinate system.

The shape cell (13) and the physical quantity cell (13') for each physical quantity are controlled in correlation with each other.

The plurality of memory layers (18) are used singly or in combination for use of the data of the shape and the physical quantity.

In the shape data dividing step (B) and the physical quantity dividing step (C), each divided shape cell is separated into an internal cell (13a) positioned inside the object, and a boundary cell (13b) including a boundary face.

The physical quantity comprises a constant value not changed by simulation, and a variable value changed as a result of simulation.

According to the present invention, an arithmetic memory program for storing substance data integrating a shape and a physical quantity is provided. This program is designed to cause a computer to execute a shape data dividing step (B) for dividing external data (12) containing shape data of an object (1) into cubic shape cells (13) having boundary planes orthogonal to one another by octree division, and storing the shape data for each shape cell; and a physical quantity dividing step (C) for octree-dividing the physical quantity of the object into different physical quantity cells (13') for each physical quantity, and storing each physical quantity for each physical quantity cell.

In addition, a computer-readable storage medium is provided which has stored the arithmetic memory program.

According to the method and the device of the invention, the external data (12) can be stored with a small storage capacity in a cell hierarchy, in which the external data (12) of the object (1) is divided into the cubit shape cells (13) having the boundary planes orthogonal to each other based on the octree division. In addition, since other than the shape cells, the different physical quantity cells (13') are provided for each physical quantity, and each physical quantity cell independently stores various physical quantities, a plurality of physical quantities such as a stress distribution, a temperature distribution, and a flow velocity distribution can be stored in a memory of a capacity proper for each physical quantity. Therefore, it is possible to reduce an entire memory capacity.

Further, the shape cell (13) and each physical quantity cell (13') for each physical quantity are stored on the different memory layers (18) of the same coordinate system. Thus, data of only a memory layer containing necessary data can be exchanged and, in representation or the like of the shape and the physical quantity, data can be efficiently used, and display time or the like can be shortened.

Since the shape cell (13) and each physical quantity cell (13') for each physical quantity are managed in correlation with each other, efficient data utilization can be achieved.

Therefore, on the plurality of memory layers (18) of the shape and the physical quantity, the shape, the structure, the physical quantity information and the history can be managed in a unified manner. Singly or in combination thereof, the data regarding the series of steps from designing to fabricating, assembling, testing, and evaluating can be managed on the plurality of memory layers, and CAD and simulation can be unified.

In short, according to the present invention, since not only the shape but also the physical attribute of the object can be stored and represented, with its hierarchical data as a platform, it is possible to build a high simulation technology, an interface technology between a human and an object, and the like.

The other objects and advantages of the present invention will be apparent from the following description with reference to the attached drawings.

### BRIEF DESCRIPTION OF THE DRAWINGS

FIG. 1 is a constitutional view of an arithmetic memory device for executing a substance data storing method of the present invention.
FIG. 2 is a flowchart of the substance data storing method of the invention, and its program.
FIGS. 3(A) to 3(D) are explanatory views of a data structure in the method and the program of the invention.
FIG. 4 is a schematic view two-dimensionally showing a dividing method of the present invention.
FIGS. 5(A) and 5(B) are schematic views showing comparison between a conventional octree (A) and a dividing method (B) of the present invention (corrected octree).
FIG. 6 is a comparative view of a surface CAD and a volume CAD.
FIG. 7 is a schematic view of leveled-up common recognition by the volume CAD.
FIGS. 8(a) and 8(b) are schematic views of cell divisions necessary in different physical quantities.
FIGS. 9(a) and 9(b) are schematic views of memory systems of physical quantities A and B.
FIGS. 10(a) and 10(b) are schematic views of memory areas of the physical quantities A and B.
FIGS. 11(A) and 11(B) are comparative views of S-CAD data (A) and V-CAD data (B) of a previously filed invention.
FIGS. 12(A) and 12(B) are comparative views of stress distribution data.
FIGS. 13(A) and 13(B) are comparative views of temperature distribution data.
FIGS. 14(A) to 14(C) are views showing the substance data storing method of the present invention.
FIG. 15 is a view showing a V-CAD data storing method of the previously filed invention.
FIGS. 16(A) and 16(B) are schematic views showing a method for using a plurality of layers according to the present invention.

### DESCRIPTION OF THE PREFERRED EMBODIMENTS

Next, the preferred embodiments of the present invention will be described with reference to the accompanying drawings.

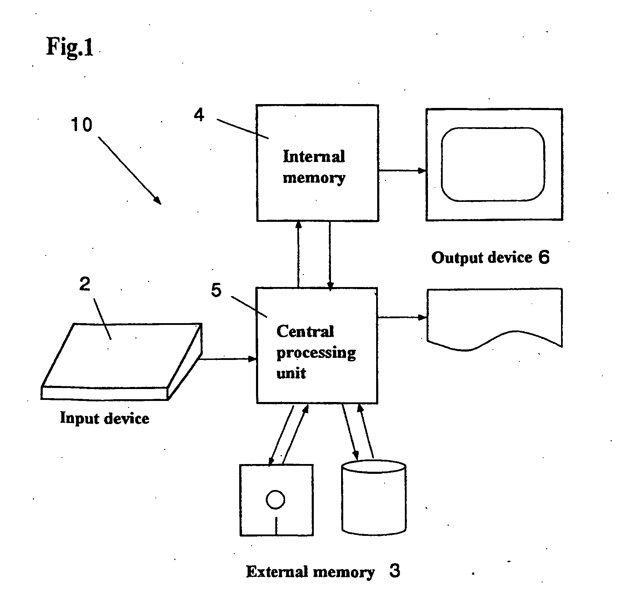

FIG. 1 is a constitutional view of an arithmetic memory device for executing a substance data storing method of the present invention. As shown, an arithmetic memory device 10 of the invention comprises an input unit 2, an external memory 3, an internal memory 4, a central processing unit 5, and an output unit 6.

The input unit 2 is, for example a keyboard, which enters external data 12 containing shape data of an object 1. The external memory 3 is a hard disk, a floppy disk, a magnetic tape, a compact disk or the like, which stores substance data integrating a shape and a physical quantity, and its arithmetic memory program. The internal memory 4 is, for example a RAM, a ROM or the like, which stores arithmetic information. The central processing unit (CPU) 5 intensively processes an arithmetic operation, an input/output operation or the like, and executes the memory program with the internal memory 4. The output unit 6 includes, for example a display and a printer, and outputs the stored substance data, and a result of executing the memory program.

In the arithmetic memory device 10 of the invention, by the external memory 3, the internal memory 4, and the central processing unit 5, the external data is divided into cubic shape cells 13 having boundary planes orthogonal to one another based on octree division, the shape data is stored for each shape cell, a physical quantity of the object is divided into different physical quantity cells 13' for each physical quantity based on octree division, and each physical quantity is stored for each physical quantity cell.

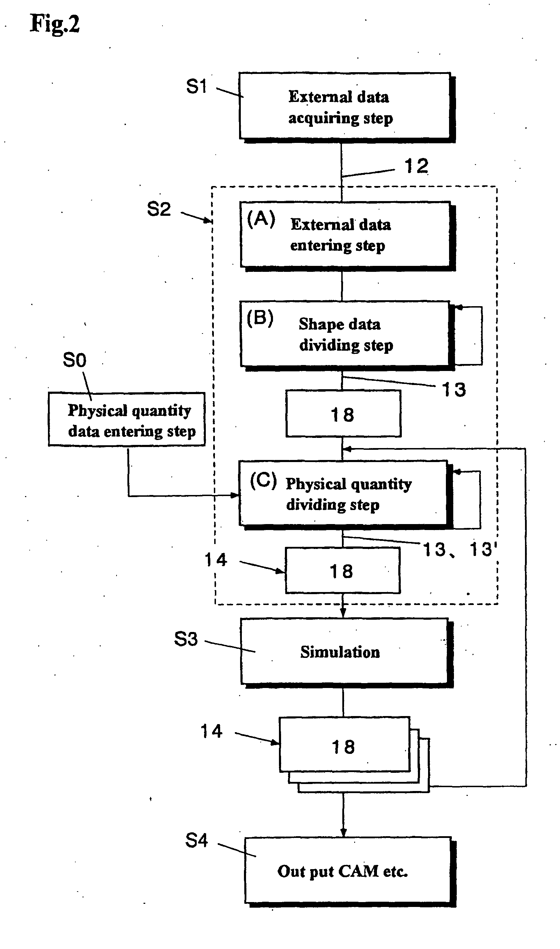

FIG. 2 is a flowchart showing the substance data storing method of the invention and its program. As shown, the method of the invention comprises an external data entering step (A), a shape data dividing step (B) and a physical quantity dividing step (C). An arithmetic memory program and a storage medium of the invention cause a computer to execute the external data entering step (A), the shape data dividing step (B) and the physical quantity dividing step (C).

In the external data entering step (A), the external data 12 containing the shape data of the object 1 obtained in external data acquiring step S1 is entered to the computer or the like, which has stored the method of the invention. In the shape data dividing step (B), the external data 12 is divided into cubic shape cells 13 having boundary planes orthogonal to one another based on octree division, and shape data is stored for each shape cell. Data of the shape cell 13 is stored in a memory layer 18 for external data.

In the physical quantity dividing step (C), the physical quantity of the object 1 is divided into different physical quantity cells 13' for each physical quantity based on octree division, and each physical quantity is stored for each physical quantity cell. The physical quantity of the object 1 may be directly entered in physical quantity data entering step S0, or data obtained in different simulation may be used. Data of the physical quantity cell 13' is stored on a different layer 18 in the same coordinate system as that of the shape cell 13.

The shape cell 13 and each physical quantity cell 13' for each physical quantity are managed in correlation with each other. This correlation can be set by storing, for example a file name of a data file (shape cell 13 or each physical quantity cell 13') corresponding to a header of one or both data files. The invention is not limited to this correlation, but another well-known correction may be used. Further, management may be carried out based on algorithm intrinsic to the octree division.

Hereinafter, data by the method of the invention is referred to as "V-CAD data", and designing or simulation using this data as "volume-CAD" or "V-CAD".

As shown in FIG. 2, in step S2 constituting the method of the invention, the shape data dividing step (A) and the physical quantity dividing step (C) are repeated when necessary. By using V-CAD data 14 on the memory layer 18, simulations of, for example designing, analyzing, fabricating, assembling, testing and the like are sequentially carried out in step S3, and results of these are also stored on different memory layers 18.

Further, in step S4, by using the plurality of memory layers 18 single or in combination, for example CAM or polygon data is outputted.

The external data 12 entered from the external unit is polygon data representing a polyhedron, data representing a tetrahedron or hexahedron element used for a finite element method, curved surface data used for a three-dimensional CAD or a CG tool, or data representing a surface of another cube by information containing a partial plane or curved place.

Other than the above-described data (referred to as S-CAD data), the external data 12 may be (1) data directly prepared by a human entering operation through an interface of V-CAD's own (V-interface), (2) surface digitized data of a measuring device, a sensor, a digitizer or the like, and (3) Volume data having internal information, such as voxel data used for CT scanning, MRI and generally Volume rendering.

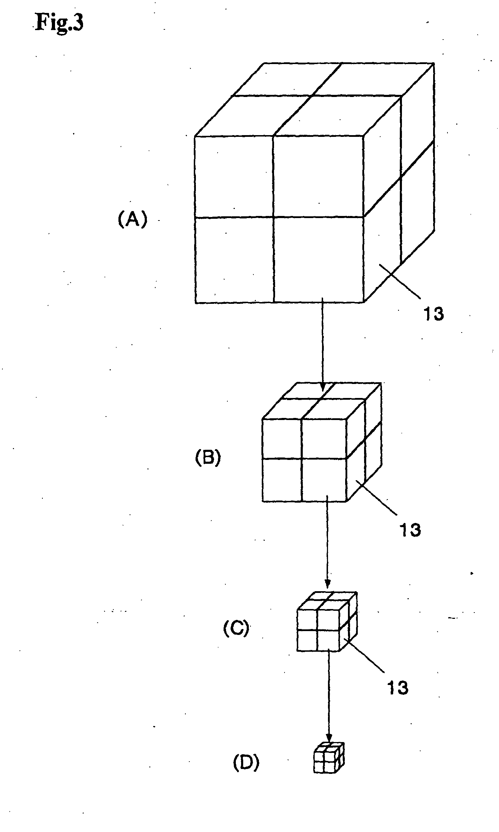

FIG. 3 is an explanatory view of a data structure in the method and the program of the invention. In the above-described shape data dividing step (B) and physical quantity dividing step (C), space division is carried out based on a corrected octree. In the octree representation, i.e., the space division by the octree, a reference cube 13 including a target cube (object) is divided into eight parts (A), and 8-division processing is recursively repeated in a manner of (B), (C) and (D) until a cube is completely included in each area or excluded. This octree division enables an amount of data to be reduced more greatly than that in the voxel representation.

Space areas obtained by the octree space division are called cells 13 and 13' (shape cell and physical quantity cell). The cell is a cube having boundary planes orthogonal to one another. An area occupying a space is represented by a hierarchical structure by the cells, the number of divisions or resolution. Accordingly, the object in the entire space is represented by stacking cells of difference sizes.

That is, in the shape data dividing step (B), boundary and internal physical quantities are converted from the external data 13 into the following substance data 14 (V-CAD data). The shape data is represented strictly (e.g., in the case of a plane, it can be reconstructed by included 3 points) or approximately within designated tolerance (threshold designated with respect to position, tangent, normal, curvature and connectivity with adjacent portions thereof).

In the shape data dividing step (B) of the invention, until representation by a breaking point on a ridge line is assured, re-division is carried out to satisfy a normal, main curvature or continuity. Strict representation is made up to quadratic curved surface, and a free curved surface is approximately represented by an in-cell curved surface based on a plane or a quadratic curved surface. Thus, only a geometrical intrinsic amount is saved.

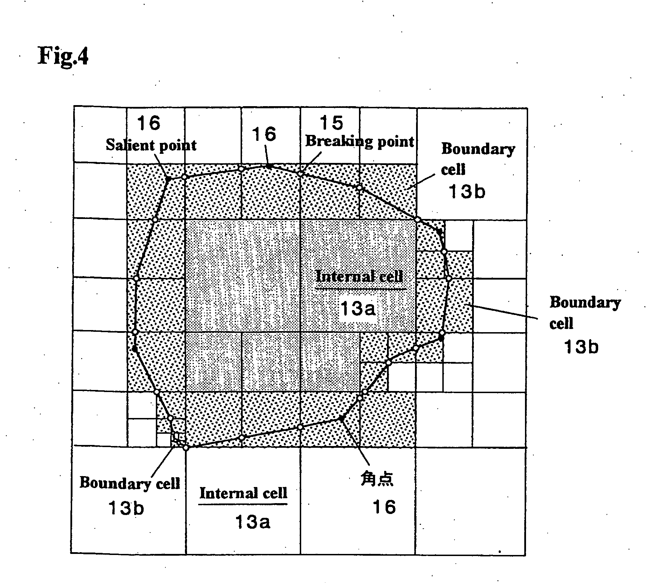

FIG. 4 is a schematic view two-dimensionally showing a dividing method of the present invention. According to the invention, in the shape data dividing step (B) and the physical quantity dividing step (C), each divided cell 13 is separated into an internal cell 13a positioned inside the object, and a boundary cell 13b including a boundary face.

That is, in the invention, by using a corrected octree for representing the boundary cell 13b, a cell completely included inside is composed of an internal cell 13a (cube) having a largest size, and a cell containing boundary information from the external data 12 is provided as a boundary cell 13b. Each cell 13b is strictly or approximately substituted with breaking points 15 on a 12 ridge lines three-dimensionally or 4 ridge lines two-dimensionally (indicated by white circles in the drawing).

The boundary cell 13b is divided by octree until breaking points 15 are obtained enough to reconstruct boundary shape elements constituting a boundary included in the external data 12 (strictly for a curved surface to be analyzed, such as a plane or a quadratic curved surface, and approximately for other boundary shape elements represented by free curved surfaces or discrete point groups).

For example, a space is divided by octree in a hierarchical manner until in the case of one line segment, 2 points thereon become breaking points 15 on a cell ridge line, 3 points become breaking points in the case of a plane, 3 points in the case of quadratic curve, 4 points in the case of quadratic curved surface, and for each of polynomial and rational curved surfaces, necessary and sufficient points and a cell ridge line are discovered in a defined range if a representation formula of the external data is known.

In other words, re-division of a target place is carried out until designated resolution is satisfied on a boundary (surface) portion, or a changing rate of a value of an analysis result (stress, distortion, pressure flow velocity or the like) owned by each cell does not exceeds a designated threshold).

For a salient point 16 (indicated by black circle in the drawing) of the boundary cell 13b including a plurality of boundary shape elements, division is not made more than necessary. It is because its internal boundary can be represented indirectly as a line of intersection of a boundary represented by breaking points 15 owned by an adjacent boundary cell (having breaking points enough for reconstruction, and divided until complete crossing of boundary elements).

Thus, as information regarding a shape stored in the cell, the V-CAD data 14 becomes an index indicating a cell position, the number of divisions or resolution indicating a degree of detail in the hierarchy, a pointer indicating an adjacent cell, the number of breaking points, a coordinate value, normal, curvature or the like as occasion demands.

In the V-CAD, node information or a value of a result is held on a lowermost layer in Euler manner. In order to set minimum resolution as large as possible in re-division, a method is defined for deciding a threshold (tolerance) regarding each of a position of a boundary, continuity of normal or tangent, and continuity of curvature.

A physical quantity of each cell is largely classified into two types, i.e., a constant value not changed in value, and a variable value changed in value by a result of simulation.

Examples of the constant value may include a material characteristic (elastic coefficient (Young's modulus, yield value)), an N value (order of elongation in plastic deformation), tensile strength, Poisson's ratio (shearing hardness), a temperature, a processing speed), a friction characteristic (as characteristics of lubricant: viscosity, shearing friction coefficient, coulomb friction), and a processing (boundary) condition (moving vector of a tool, or a cooling speed).

Examples of the variable value may include stress (symmetrical tensile amount (6 variables)), distortion (symmetrical tensile (6 variables)), a flow velocity, a pressure, a temperature and the like. When a difference exceeding a pre-designated permissible value between adjacent internal cells in the process of simulation occurs in variable values, the above-described re-division by octree is automatically carried out until the difference is contained within the permissible value.

### (Method for automatically deciding resolution)

With regard to automatic deciding of resolution, in addition to the above-described method using requirements limited by the shape or using the difference in physical quantities between the adjacent cells, there is a method using requirements determined by a memory or a calculation time and determined by pre-designated absolute accuracy (e.g., division is stopped when a cell width becomes 1 µm) and, in this method, when any one of these requirements is satisfied, the space octree division is stopped. Accordingly, representation having minimum necessary resolution (degree of detail) is achieved, making mounting more practical.

The method of the invention for storing substance data integrating a shape and a physical quantity is used for data representation in entry, output and the midway of analysis/simulation such as solid structure analysis, large deformation analysis (rigid plastic and elastic plastic analysis), heat/fluid analysis, and flow analysis in C-simulation or the like, in addition to shape defining, changing, displaying, holding, examining and evaluating in S-CAD or the like. Further, the method can be used for generation of data for removal processing, addition processing and deformation processing in A-CAM or D-fabrication, creation of data for analysis, visualization, comparative evaluation, surface or inside measurement, result holding, displaying, various analyses, and comparative evaluation with processing data. As the displaying method, two types are available, i.e., surface rendering and volume rendering.

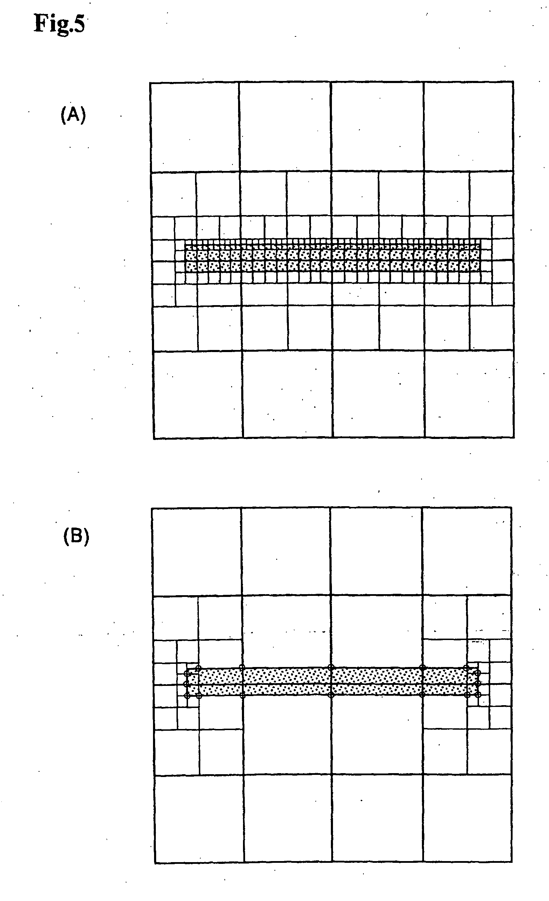

FIG. 5 is a two-dimensional schematic view similar to that of FIG. 4, showing the dividing method (corrected octree) of the invention in comparison with a conventional octree division. In the drawing, an example (A) is a normal octree division, and an example (B) is a corrected octree division of the invention. In the examples, thin plates (dotted parts) difficult for space dividing methods such as Octree are divided.

From the drawing, it can be understood that in the corrected octree division (B) of the invention, since surface re-construction by breaking points is used, the number of divisions is smaller than that of the normal octree division (A).

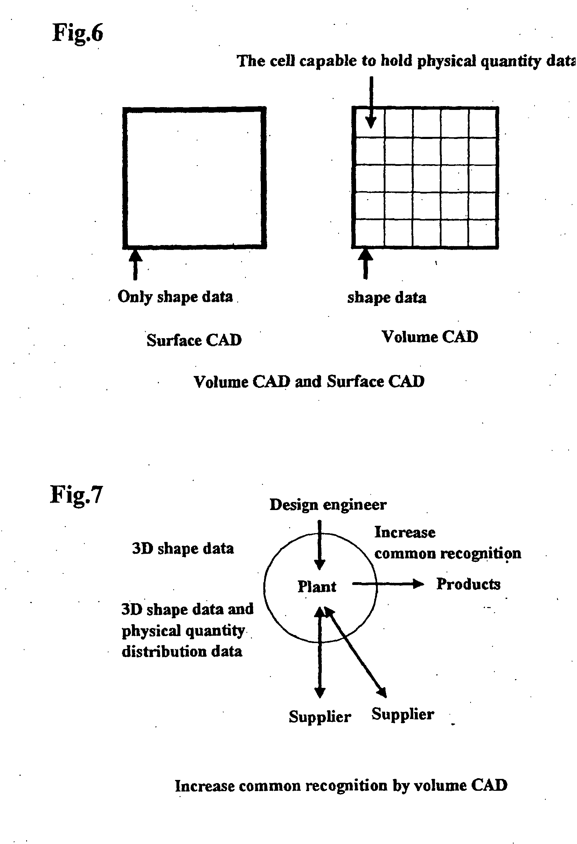

A schematic view of FIG. 6 shows examination of integrating various bits of information necessary for "manufacturing" around a new CAD called a volume CAD capable of holding volume information rather than the conventional surface CAD only holding surface information. In the volume CAD, in a cell divided based on an octree (tetratree) method for reducing data weight, surface data and a physical quantity necessary for "manufacturing" can be stored.

By adding a physical quantity or the like indispensable to "manufacturing" to the volume CAD, as schematically shown in FIG. 7, it is possible to obtain not only common recognition including common recognition so far limited to the shape data by the surface CAD among persons engaged in each designing process but also common recognition to a physical phenomenon. Thus, more efficient "manufacturing" can be expected.

The invention is directed to a data structure for efficiently holding a physical quantity on the volume CAD.

### (Storing of substance data on layer)

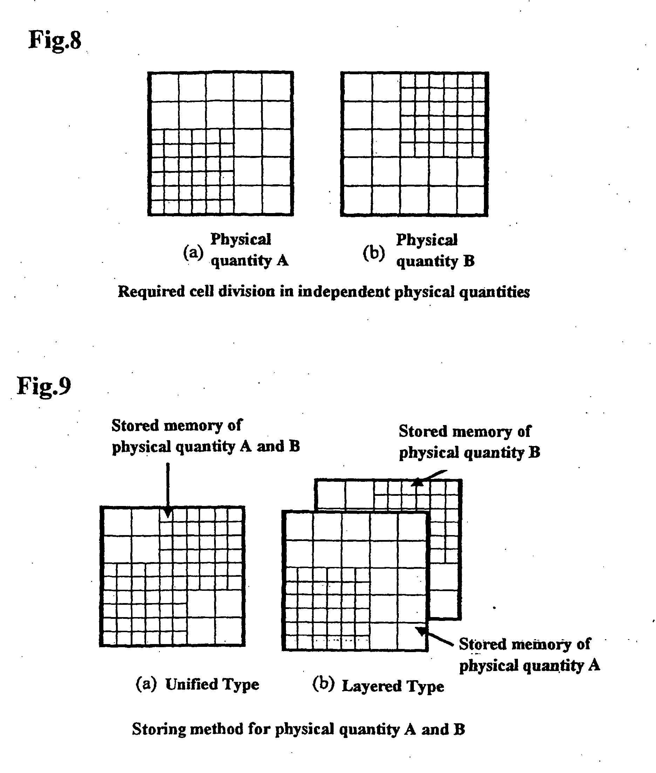

In the volume CAD, as the octree division is carried out at the CAD side, the division is always dependent on a shape. On the other hand, as shown in FIGS. 8(a) and 8(b), in the object depending on an external condition, each physical quantity necessary for real designing of a stress value or the like in use of a finite element method structure analysis may exhibit a distribution different from shape division.

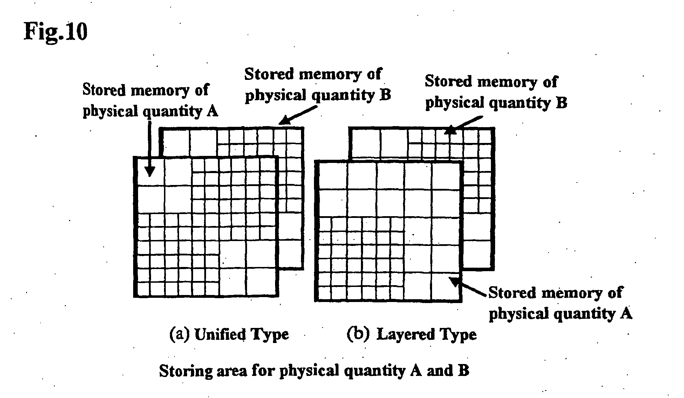

In such a case, there may be a correlation or no correlation between physical quantities A and B. The cell division dependent on the shape may also be considered as cell division for processing data of "detailed representation of shape". Instead of holding all physical quantities unified and necessary in one cell division as shown in FIG. 9(a), proper cell division is prepared and stored for each physical quantity (including data of detailed representation of shape) as shown in FIG. 9(b). Accordingly, effective data utilization can be achieved. Each cell division is called a layer. In this case, as shown in FIGS. 10(a) and 10(b), it is expected that the layer type storage of a physical quantity will be more advantageous than that of the unified cell storage in terms of memory areas.

### (Data processing and displaying)

Displaying of each physical quantity can be classified into a case needing detailed shape information, and a case not needing detailed shape information. The layer for storing the physical quantity has certain space information (cell division). Thus, if necessary resolution is low, displaying by the single physical quantity layer may be satisfactory. In the case of display with more detailed resolution, the displaying is carried out by addition with the layer having detailed shape data.

### (Reduction in weight of data)

The layer division enables only necessary physical data to be distributed. Thus, it is possible to prevent physical quantity representation in V-CAD from being redundant.

### [Embodiment]

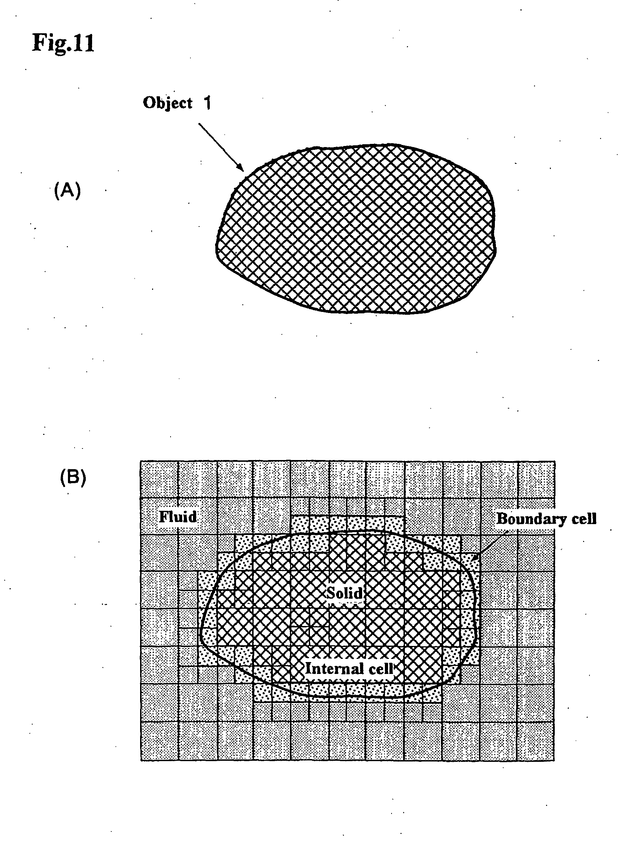

FIGS. 11(A) to 16(B) schematically show an embodiment of the present invention.

FIG. 11(A) shows an example of S-CAD data, and FIG. 11(B) an example of V-CAD data of a previously filed invention. The V-CAD data of the previous invention is similar to that of the present invention in that external data of an object 1 is divided into internal and boundary cells based on octree division. However, it is different from the prevent invention in that shape data of the object 1, and each physical quantity are processed by the same octree division.

In the present invention, as described above, the shape cell 13 and each physical quantity cell 13' for each physical quantity are stored on the different memory layers 18.

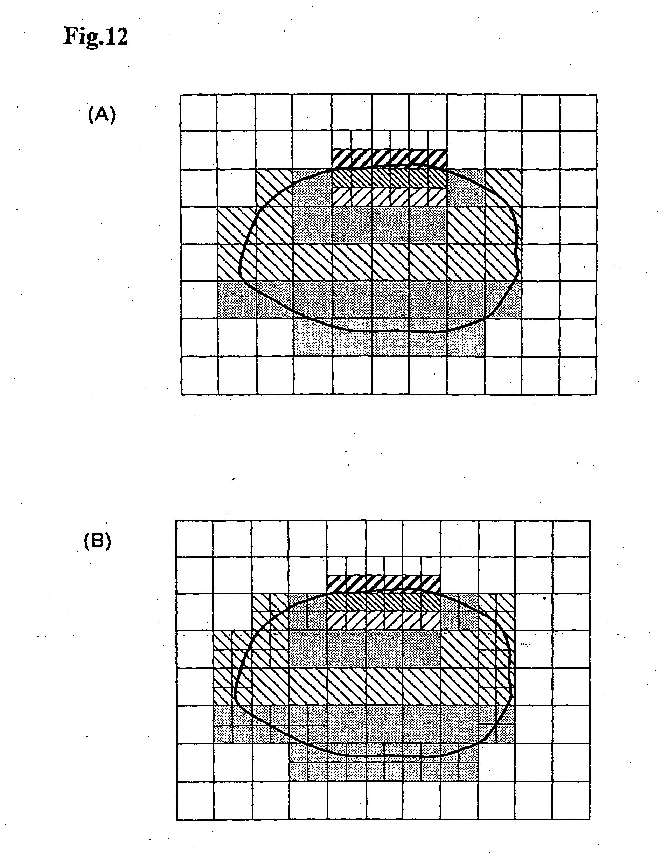

FIGS. 12(A) and 12(B) show examples of stress distribution data: FIG. 12(A) showing a memory layer of stress distribution of the present invention; and FIG. 12(B) V-CAD data of the previous invention. In each drawing, patterns in cells separate sizes of stress. From the examples, it can be understood that with respect to the same stress distribution, the number of octree divisions is smaller in the example (A) of the present invention, hierarchy can be accordingly made shallower, and a memory can be made smaller.

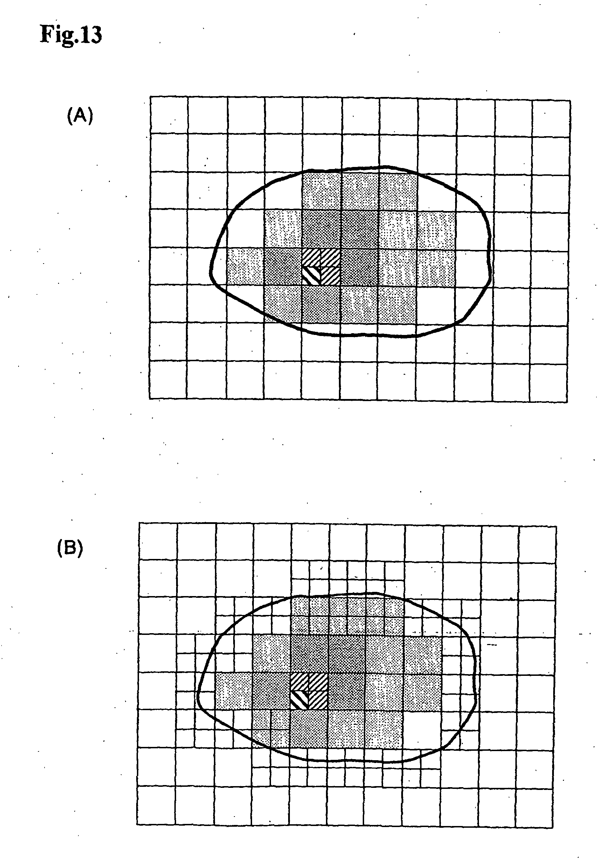

FIGS. 13(A) and 13(B) show examples of temperature distribution data: FIG. 13(A) showing a memory layer of temperature distribution of the present invention; and FIG. 13(B) V-CAD data of the previous invention. In each drawing, patterns in cells separate sizes of temperatures. From the examples, it can be understood that with respect to the same temperature distribution, the number of octree divisions is smaller in the example (A) of the present invention, hierarchy can be accordingly made shallower, and a memory can be made smaller.

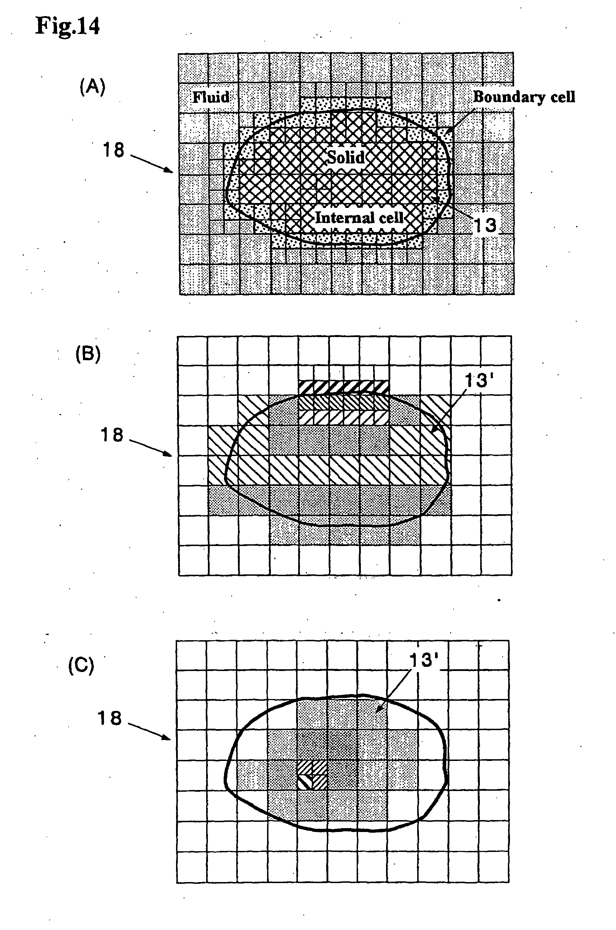

FIGS. 14(A) to 14(C) show the method of the present invention for storing substance data, in which a memory layer 18 for storing the shape cell 13, and a different memory layer 18 for storing each physical quantity cell 13' for each physical quantity are provided. Preferably, the plurality of layers 18 are in the same coordinate system, but the invention is not limited to this as long as a correlation can be set.

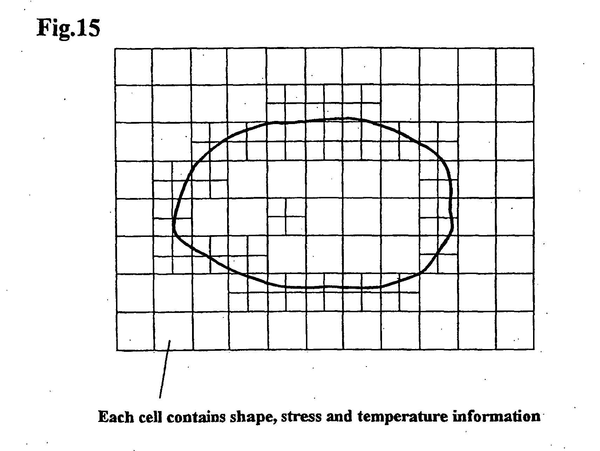

On the other hand, V-CAD data of the previous invention shown in FIG. 15 is similar to that of the present invention in that the external data of the object 1 is divided into internal and boundary cells based on octree division. However, it is different from the present invention in that each cell has information on a shape, stress, a temperature or the like.

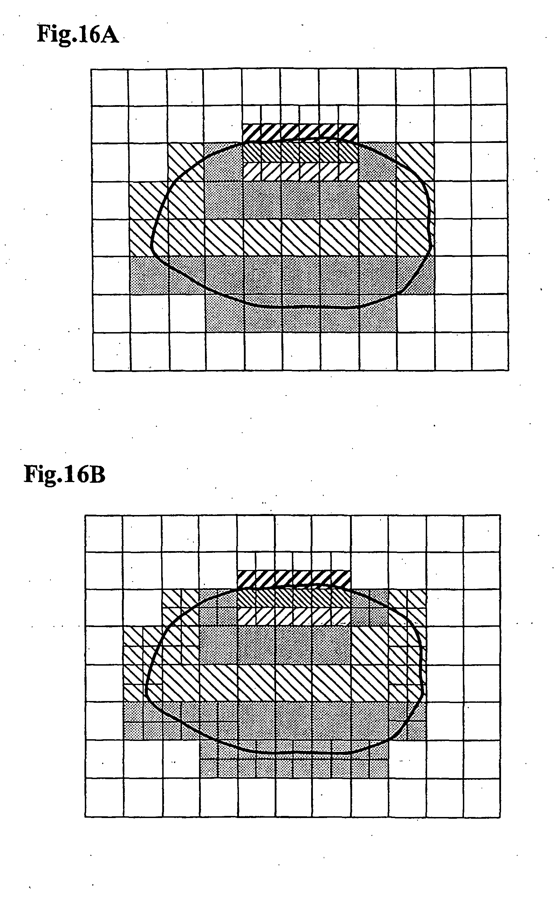

FIGS. 16(A) and 16(B) schematically show a method of the present invention for using a plurality of layers. For example, in the case of displaying stress distribution, as shown in FIG. 16(A), for rough displaying, it can be carried out only by the stress distribution layer. In the case of detailed shape displaying, as shown in FIG. 16(B), displaying is carried out by using both of the stress distribution layer and the shape layer. Preferably, this data is temporarily created in displaying for a data capacity, but a different layer 18 may be used as occasion demands.

As described above, all the data are always used in the V-CAD data of the previous invention. In the method of the present invention, however, only necessary ones among the plurality of memory layers 18 are used as occasion arises.

According to the method of the present invention, it is possible to store the external data 12 by a small storage capacity as the cell hierarchy, in which the external data 12 of the object 1 is divided into cubic shape cells 13 having boundary planes orthogonal to one another based on the octree division. The different physical quantity cells 13' are provided for each physical quantity separately from the shape cells, and each physical quantity cell independently stores various physical quantities. Thus, a plurality of physical quantities such as stress distribution, temperature distribution and flow velocity distribution can be stored in the memory of a capacity proper for each physical quantity. Therefore, the entire memory capacity can be reduced.

Further, the shape cell 13, and each physical quantity cell 13' for each physical quantity are stored on the different memory layers 18 in the same coordinate system. Thus, data can be exchanged only for the memory layer including necessary data and, in displaying or the like of the shape and the physical quantity, efficient data utilization can be carried out. Therefore, display time or the like can be shortened.

Therefore, by the plurality of memory layers 18 of the shape and the physical quantity, the shape, the structure, the physical quantity information and the history of the object can be managed in a unified manner. Singly or in combination, data regarding a series of steps from designing to fabricating, assembling, testing, evaluating and the like can be managed by the plurality of memory layers. CAD and simulation can be unified.

That is, according to the present invention, the object can be stored and represented, including not only the shape but also the physical attributes, with its hierarchical data as a platform, so that it is possible to build a high-level simulation technology, and an interface technology between a human and the object.

As described above, according to the present invention, the plurality of memory layers can be prepared in accordance with distribution independence of each physical quantity, and each physical quantity can be stored with sufficient accuracy without changing initial V-CAD cell information. Thus, since the use of the substance data by the layer enables memory cell division to be changed for each physical quantity, efficient data utilization can be achieved.

Therefore, according to the method and the program of the present invention for storing the substance data integrating the shape and the physical quantity, the substance data integrating the shape and the plurality of physical quantities can be stored by a small storage capacity with sufficient accuracy without changing the initial V-CAD cell information. Thus, the invention is remarkably advantageous in that the shape, the structure, the physical quantity information and the history of the object can be managed in a unified manner, the data regarding a series of steps from designing to fabricating, assembling, testing, evaluating and the like can be managed by the same data, and CAD and simulation can be unified.

The present invention has been described by way of some preferred embodiments. However, it can be understood that a scope of rights is not limited to the described embodiments. On the contrary, the scope of right of the invention include all improvements, modifications and equivalents specified in appended claims.

## Claims

1. A method for storing substance data integrating a shape and a physical quantity, comprising: an external data entering step (A) for entering external data (12) containing shape data of an object (1); a shape data dividing step (B) for dividing the external data into cubic shape cells (13) having boundary planes orthogonal to one another by octree division, and storing shape data for each cell; and a physical quantity dividing step (C) for dividing a physical quantity of the object into different physical quantity cells (13') for each physical quantity by octree division, and storing each physical quantity for each physical quantity cell.

2. The method for storing the substance data integrating the shape and the physical quantity according to claim 1, wherein the shape cell (13) and the physical quantity cell (13') for each physical quantity are stored on different memory layers (18) in the same coordinate system.

3. The method for storing the substance data integrating the shape and the physical quantity according to claim 1, wherein the shape cell (13) and the physical quantity cell (13') for each physical quantity are controlled in correlation with each other.

4. The method for storing the substance data integrating the shape and the physical quantity according to claim 1, wherein the plurality of memory layers (18) are used singly or in combination for use of the data of the shape and the physical quantity.

5. The method for storing the substance data integrating the shape and the physical quantity according to claim 1, wherein in the shape data dividing step (B) and the physical quantity dividing step (C), each divided shape cell is separated into an internal cell (13a) positioned inside the object, and a boundary cell (13b) including a boundary face.

6. The method for storing the substance data integrating the shape and the physical quantity according to claim 1, wherein the physical quantity comprises a constant value not changed by simulation, and a variable value changed as a result of simulation.

7. An arithmetic memory device for storing substance data integrating a shaped and a physical quantity comprising: an input unit (2) for entering external data (12) containing shape data of an object (1); an external memory (3) for storing the substance data integrating the shape and the physical quantity, and its arithmetic memory program; an internal memory (4) and a central processing unit (5) for executing the memory program; and an output unit (6) for outputting a result of the execution,
wherein the external data is divided into cubic shape cells (13) having boundary planes orthogonal to one another by octree division, shape data is stored for each shape cell, the physical quantity of the object (1) is octree-divided into different physical quantity cells (13') for each physical quantity, and each physical quantity is stored for each physical quantity cell.

8. An arithmetic memory program for storing substance data integrating a shaped and a physical quantity which causes a computer to execute a shape data dividing step (B) for dividing external data (12) containing shape data of an object (1) into cubic shape cells (13) having boundary planes orthogonal to one another by octree division, and storing the shape data for each shape cell; and a physical quantity dividing step (C) for octree-dividing the physical quantity of the object into different physical quantity cells (13') for each physical quantity, and storing each physical quantity for each physical quantity cell.

9. A computer-readable storage medium which has stored an arithmetic memory program for storing substance data integrating a shaped and a physical quantity which causes the computer to execute a shape data dividing step (B) for dividing external data (12) containing shape data of an object (1) into cubic shape cells (13) having boundary planes orthogonal to one another by octree division, and storing the shape data for each shape cell; and a physical quantity dividing step (C) for octree-dividing the physical quantity of the object into different physical quantity cells (13') for each physical quantity, and storing each physical quantity for each physical quantity cell.
